# EUROPEAN PATENT APPLICATION

(11) **EP 4 723 817 A1**
(43) Date of publication of application: **08.04.2026**
(21) Application number: 24204034.3
(22) Date of filing: 01.10.2024
(51) Int. Cl.: H05K 7/20

(54) **COOLING UNIT FOR AN INVERTER**

(71) Applicant: Valeo eAutomotive Germany GmbH, 91056 Erlangen (DE)
(72) Inventor: MARSHALL, Steven, Auburn Hills, 48326 (US)
(74) Representative: Valeo Powertrain Systems

(57) **Abstract**

The invention relates to a cooling unit (14) for an inverter (10), in particular for an inverter (10) used in an electrically powered vehicle, comprising an inlet duct (18), a nozzle plate (20), and an outlet duct (22). The outlet duct (22) is at least partially delimited by a heat transfer plate (16) adapted to receive, at its side opposite to the outlet duct, a power electronic component (12). The nozzle plate (20) comprises a plurality of nozzle openings (24), which taper from the inlet duct (18) side to the outlet duct (22) side, and the heat transfer plate (16) is provided with a deflection element at a position opposite the nozzle openings (24).

The invention further relates to an inverter (10) of an electrically powered vehicle.

## Description

The invention relates to a cooling unit for an inverter as well as an inverter of an electrically powered vehicle.

The inverter is an essential part of any vehicle which has electric drive motors supplied from a DC power source. Typical examples are hybrid vehicles or fully electrically driven vehicles which have a battery for storing electric energy. The inverter converts the DC power provided by the battery into AC power when the electric motor is to be supplied, or converts the AC power provided by the electric motor when energy is being recuperated, into DC power which is then stored in the battery.

It is known that inverter modules are actively cooled in order to dissipate the waste heat generated in power electronic components. However, it has been found that some components of the inverter module are subject to undesirably high temperatures during operation.

Cooling units developed for cooling inverters typically have a structure in which a coolant, which is directed from an inlet to an outlet, cools several power electronic components arranged next to or behind each other. Therefore, a typical problem of such cooling units is an inhomogeneous heat transfer to the coolant. The power electronic component that is first exposed to the coolant can release more heat to the coolant than the rest of the power electronic components that are exposed to the coolant afterwards. This is due to the fact that the temperature of the coolant increases along its flow path, which reduces the heat absorption capacity of the coolant. This specific problem is mainly observed in cooling units that are designed to have the lowest possible pressure loss. In cooling units with this requirement, complicated channel routing with multiple changes or reversals of direction are ruled out.

Even when a complicated channel routing is chosen, in addition to the pressure loss, the temperature of the coolant will increase with each inverter and/or electrical power component that the coolant passes. Such a cooling unit is also known as a meander cooler due to the coolant being channeled back and forth several times between the individual power electronic components.

It is also known to have a cooling unit comprising multiple meander plates stacked on top of each other, wherein each meander plate has a slightly different geometry, such that the coolant is routed slightly differently for each meander plate. This way it can be ensured that the coolant does not need to pass every power electronic component such that the temperature increase of the coolant is slowed down. However, such a meander cooler comes with its own set of problems. Most of the coolant remains unused from a thermal point of view, as about two thirds of the coolant bypasses the meander plates and therefore does not reach the interface to which the power electronic components are affixed.

Therefore, it is an object of the invention to provide a cooling unit for an inverter that effectively cools power electronic components of the inverter.

The above object is achieved by a cooling unit for an inverter, in particular for an inverter used in an electrically powered vehicle, comprising an inlet duct, a nozzle plate, and an outlet duct. The outlet duct is at least partially delimited by a heat transfer plate adapted to receive, at its side opposite to the outlet duct, a power electronic component. The nozzle plate comprises a plurality of nozzle openings, which taper from the inlet duct side to the outlet duct side, and the heat transfer plate is provided with a deflection element at a position opposite the nozzle openings. In other words, instead of one or multiple meander plate/plates, a nozzle plate is used in order to direct a coolant jet onto the power electronic components. Furthermore, in order to eliminate the stagnation zone created by the jet, the heat transfer element comprises a deflection element ensuring a more effective transport of the coolant and thereby increasing the cooling effect as a built-up of a thermal boundary layer is avoided.

The power electronic components of the inverter may be switching cells, in particular field effective transistors, more precisely metal-oxide-semiconductor field effective transistors (MOSFETs). Preferably, the semiconductor material of the MOSFETs is a silicon carbide (SiC) which contacts the heat transfer plate.

The power electronic components of the inverter may be soldered onto the heat transfer plate or may be affixed to the heat transfer plate with a heat conducting paste.

Further, the objective is solved by an inverter of an electrically powered vehicle comprising at least one power electronic component and a cooling unit as described above, wherein the cooling unit is removably mounted in the inverter. Therefore, the cooling unit may be replaced depending on the requirements of the inverter, particularly depending on the fluid dynamics of the coolant and/or the required nozzle opening sizes.

According to an embodiment of the invention, the nozzle plate comprises at least one nozzle opening for each power electronic component, preferably for each connector of each power electronic component. That way, each power electronic component, or more specifically each connector of the power electronic component, has a coolant jet directed onto it, such that each connector is supplied with "fresh coolant", i.e. coolant whose temperature has not yet increased due to the heat transferred by one or more of the power electronic components.

Typically, the connectors of the power electronic component correspond to the three phases, i.e. the U-, V- and W-phase.

According to a further embodiment, the heat transfer plate and the nozzle plate extend in a plane parallel to the power electronic components, in particular horizontally. This way it can be ensured, that each jet created by the nozzle plate has a direction perpendicular to the electronic power components such that each jet hits a power electronic component, preferably a connector of the power electronic component, and directly makes contact with the parts of the heat transfer plate that have the highest temperature for optimized cooling.

Preferably, the outlet duct may be formed between the heat transfer plate and the nozzle plate and the inlet duct may be formed between the nozzle plate and a base of the cooling unit. Accordingly, the coolant jet comes directly into contact with the heat transfer plate attached to the inverter, wherein each jet consists of coolant whose temperature has not yet increased due to contact with other power electronic components.

According to an embodiment, the cross-section of the outlet duct is smaller than the cross-section of the inlet duct. Due to the smaller cross-section of the outlet duct, the coolant has a higher velocity in the outlet duct than in the inlet duct which allows for a more effective cooling as coolant with an increased temperature due to its contact with the heat transfer plate is transported to the outlet faster.

In other words, the inlet duct may serve as a plenum chamber having a lower velocity compared to the outlet duct.

In order to further improve the flow dynamics of the coolant, the cooling unit may comprise a first deflection volume upstream and a second deflection volume downstream of and adjacent to each nozzle opening in the nozzle plate. These deflection volumes help direct the coolant and therefore ensure that transport losses due to convection and/or heat transfer are minimized.

In particular, the first and second deflection volumes are offset from each other such that the deflection volumes are located on opposite sides of the nozzle opening. Put differently, the first deflection volume is located downstream of the nozzle opening in the inlet duct whereas the second deflection volume is located upstream of the nozzle opening in the outlet duct.

Therefore, the first deflection volume helps with jet creation and minimizes the bypass possibilities of the coolant, whereas the second deflection volume decelerates and helps to direct the coolant towards the outlet.

According to a further embodiment, the deflection element is cone- or dome-shaped. In particular, the deflection element is symmetrical with regard to a central axis extending through the corresponding nozzle opening. Hence, the deflection element is located on the heat transfer plate at the exact spot the jet created by the nozzle plate impinges such that the formation of a stagnation zone is effectively avoided. Additionally, the deflection element helps with the deceleration of the jet in order to avoid a thermal boundary layer build-up. Therefore, the size of the deflection element may correspond to the size of the impingement and/or stagnation zone.

Alternatively, the deflection element may be a rib, in particular a cubic, square, triangular, rectangular, or semi-circular rib. In this case, one deflection element may be used for multiple power electronic components, or more specifically for multiple nozzle openings, located next to each other.

According to a preferred embodiment, the plurality of nozzle openings in the nozzle plate are circular.

According to a further embodiment, the nozzle plate comprises at least one projection extending from the nozzle plate towards the heat transfer plate, wherein a tapered duct is formed that extends through the nozzle plate and the projection and that corresponds to a nozzle opening. By including a projection in the vicinity of the nozzle opening, the jets produced by the nozzle plate are improved in terms of guidance and pressurization.

Preferably, the nozzle plate is formed by punching or die-casting. This allows for a cheap, fast, and easy production of the nozzle plate such that the overall cost of the cooling unit and consequently of the inverter can be kept low.

The exact form and size of the nozzle openings depends on the fluid dynamics of the coolant, in particular on the flow of the coolant and the available pressure. Therefore, nozzle plates for different vehicles for example may differ from each other.

Since the nozzle plate is typically integrated in the cooling unit, depending on the requirements for cooling a specific inverter, different cooling units comprising different nozzle plates can be used.

Further, the cooling unit may comprise a first deflection area associated with the inlet duct and/or a second deflection area associated with the outlet duct. Said deflection areas help with the removal of the coolant such that a build-up of a thermal boundary layer is avoided. In addition, these deflection areas help to drain the coolant from the cooling unit.

Preferably, the deflection areas of the inlet duct and the outlet duct are opposite of the inlet and outlet respectively. Expressed differently, the first deflection are is located in the inlet duct opposite of the inlet whereas the second deflection area is located inside the outlet duct opposite of the outlet.

Further features and advantages can be found in the following description and in the figures to which reference is made. In the figures,
- Figure 1 shows a schematic cross-section of an inverter with a cooling unit in a perspective view;
- Figure 2 shows a perspective view of the inverter and the cooling unit shown in figure 1;
- Figure 3 schematically shows a detailed view of a power electronic component of the inverter shown in figure 1 in a perspective view;
- Figure 4 shows a detailed cross-section of a nozzle opening;
- Figure 5 schematically shows the temperature distribution in a cross-section of the inverter and the cooling unit shown in figure 1; and
- Figure 6 schematically shows a top view of the inverter shown in figure 1.

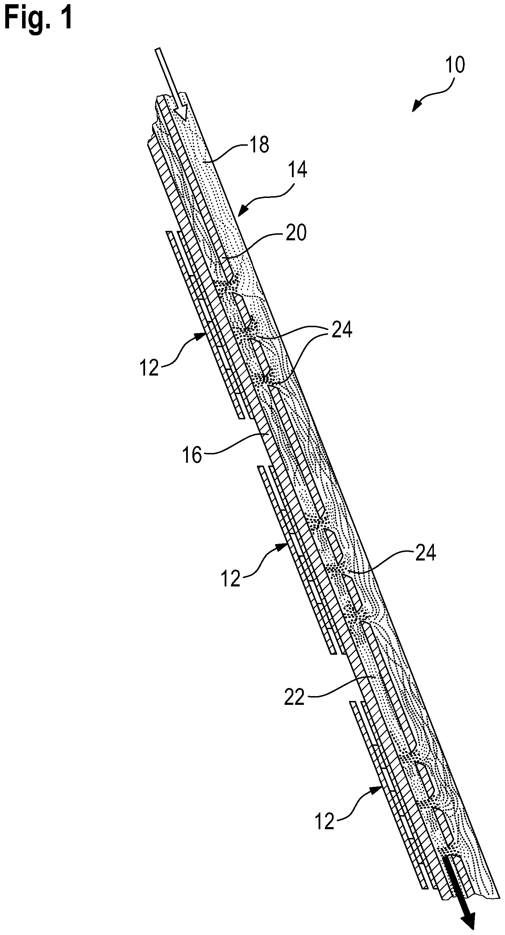

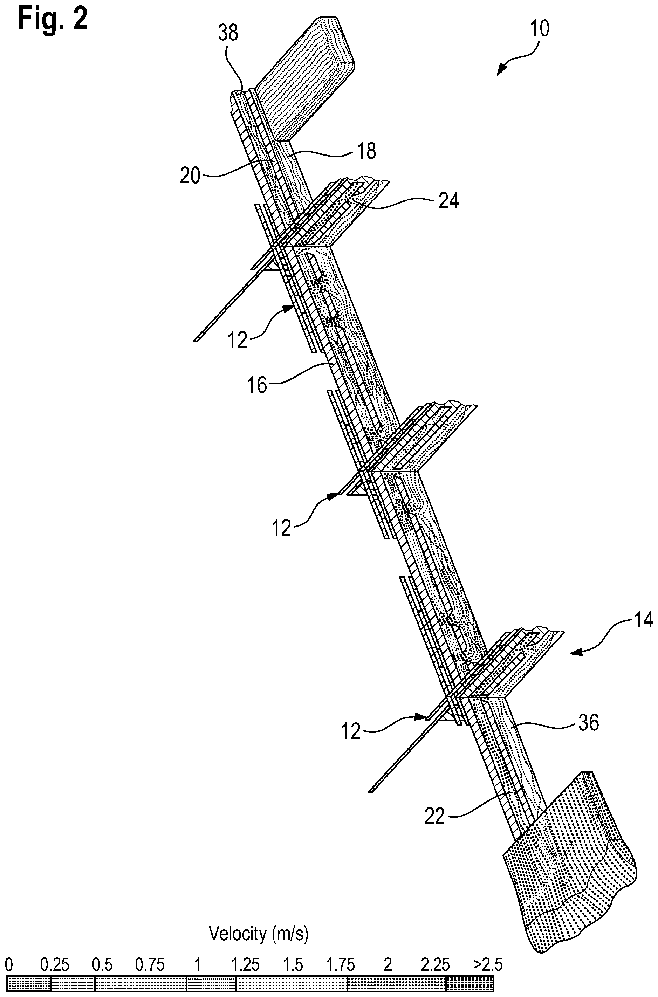

Figures 1 and 2 schematically show an inverter 10 which can be used in an electrically powered vehicle (not shown).

The inverter 10 comprises a plurality of power electronic components 12. The power electronic components 12 may for example be switching components, in particular field effective transistors, preferably metal-oxide-semiconductor field effective transistors (MOSFETs). Preferably, the semiconductor material of the MOSFETs is a silicon carbide (SiC).

Generally, the inverter 10 comprises about 60 power electronic components 12.

However, the number of power electronic components 12 may be higher or lower than 60 as well as higher or lower than the number of power electronic components 12 shown in the Figures.

The power electronic components 12 are connected to a cooling unit 14, in particular to a heat transfer plate 16 of the cooling unit 14.

In particular, the power electronic components 12 may be soldered onto the heat transfer plate 16. Alternatively, the power electronic components 12 may be affixed to the heat transfer plate 16 via a heat conductive paste.

Besides the heat transfer plate 16, the cooling unit 14 comprises an inlet duct 18, a nozzle plate 20, and an outlet duct 22. The arrows shown in Figure 1 indicate the flow of a coolant through the inlet duct 18 and the outlet duct 22.

The outlet duct 22 is at least partially delimited by the heat transfer plate 16. In other words, the power electronic components 12, which produce heat, are connected to the heat transfer plate 16 which is in direct connection with the outlet duct 22 and hence ensures a fast and effective dissipation of heat.

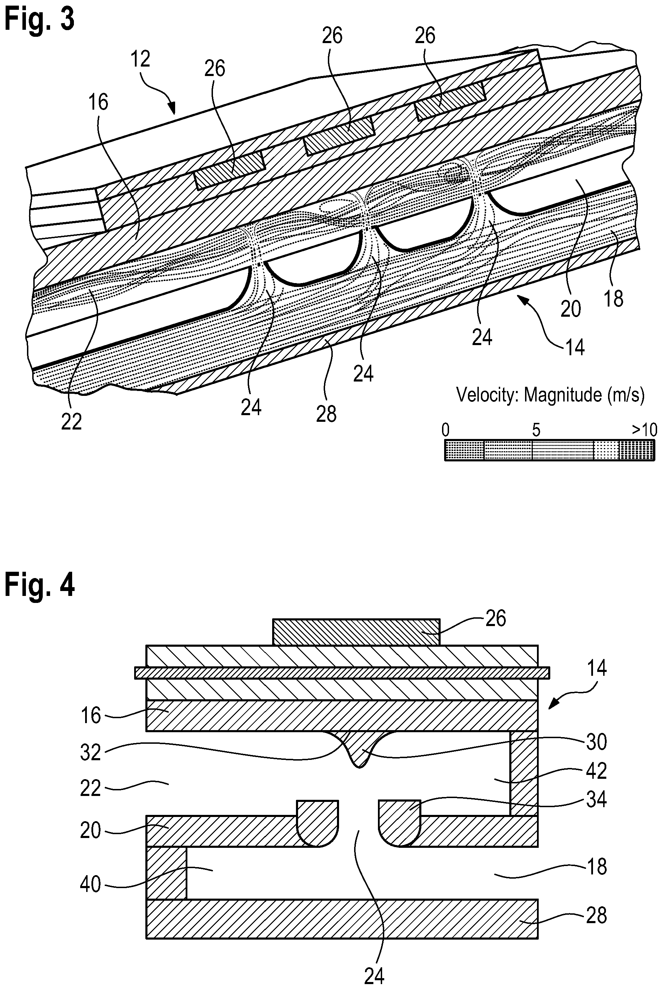

It is shown in Figure 1 and in more detail in Figure 4 that the nozzle plate 20 comprises a plurality of nozzle openings 24 which taper from the inlet duct 18 side towards the outlet duct 22 side. In particular, it can be seen that the nozzle plate 20 comprises a nozzle opening 24 for each connector 26 of the power electronic components 12. The connectors 26 of the power electronic components 12 correspond to the three phases, i.e. the U-, V-, and W-phase.

It can also be seen in the Figures that the heat transfer plate 16 and the nozzle plate 20 are parallel to each other, in particular that they extend in planes that are parallel to each other.

Further, the heat transfer plate 16 and the nozzle plate 20 are parallel to a plane comprising the power electronic components 12 such that a jet of coolant created by the nozzle plate 20 is perpendicular to the power electronic components 12.

In particular, the heat transfer plate 16, the nozzle plate 20, and the plane comprising the power electronic components 12 preferably extend horizontally.

The outlet duct 22 is formed between the heat transfer plate 16 and the nozzle plate 20, whereas the inlet duct 18 is formed between the nozzle plate 20 and a base 28 of the cooling unit 14.

Further, the cooling unit 14, in particular the heat transfer plate 16, is provided with a deflection element 30 positioned opposite the nozzle openings 24 as shown in Figure 4.

Preferably, a deflection element 30 is positioned opposite of each nozzle opening 24 of the plurality of nozzle openings 24.

The deflection element 30 is cone, dome, or "volcano" shaped and is preferably symmetrical with regard to a central axis extending through the corresponding nozzle opening 24.

Ideally, the size of the deflection element 30 corresponds to the size of the nozzle opening 24. Put differently, the base 32 of the deflection element 30, i.e. the part of the deflection element 30 connected to the heat transfer plate 16, preferably corresponds to the widest part of the nozzle opening 24.

Alternatively, the deflection element 30 may be a rib, in particular a cubic, square, triangular, rectangular, or semi-circular rib. If the deflection element 30 corresponds to a rib, it may be used for multiple nozzle openings 24 arranged next to or behind each other.

It is also shown in Figure 4 that the nozzle plate 20 comprises a projection 34 that extends from the nozzle plate 20 towards the heat transfer plate 16.

Preferably, the projection 34 is integrally formed with the nozzle plate 20 and constitutes an edge of the nozzle opening 34.

Hence, the projections 34 are positioned at the nozzle openings 24 such that the nozzle openings 24 not only taper from the inlet duct 18 side towards the outlet duct 22 side of the nozzle plate 20 but instead taper from the inlet duct 18 side towards the end of the projection 34 on the outlet duct 22 side. These projections 34 may therefore help to create cooling jets.

Preferably, the nozzle openings 24 in the nozzle plate 20 are circular. Alternatively, the nozzle openings 24 may also be elliptical, square with rounded edges or rectangular with rounded edges.

Further, since the nozzle plate 20 is formed by punching or die-casting, circular nozzle openings 24 help to reduce the time needed for the production of the nozzle plate 20.

However, the exact geometric form and size of the nozzle openings 24 depends on the fluid dynamics of the coolant that is to be used, in particular the flow dynamics and the available pressure of the coolant. Accordingly, the nozzle openings 24 may differ from application to application.

Based on Figures 1 to 6, the cooling of the power electronic components 12 using the cooling unit 14 will be described.

In the embodiment shown in the Figures, the coolant enters the cooling unit 14 from the lower right side, as indicated by the arrow in Figure 1.

In order to provide a certain mass flow of the coolant or more precisely a certain velocity of the coolant, a pump (not shown) may be provided upstream of the inlet duct 18 that pumps the coolant into the cooling unit 14.

Generally, the velocity of the coolant decreases the further it travels down the inlet duct 18.

Part of the coolant is pushed through the nozzle openings 24 and the nozzle plate 20 such that a coolant jet is created.

Due to the arrangement of the nozzle plate 20, the heat transfer plate 16 and the power electronic component 12, the coolant jet is perpendicular to the power electronic components 12 and directly impinges on the part where the power electronic components 12 are affixed to the heat transfer plate 16.

Since the nozzle openings 24 taper from the inlet duct 18 side of the nozzle plate 20 to the outlet duct 22 side of the nozzle plate 20 or the projection 34, the velocity of the coolant is increased such that the coolant jets impinge on the heat transfer plate 16 with velocities of 2.5 meters per second and higher, whereas the average velocity of the coolant in the inlet duct 18 is closer to 1.2 m/s.

The deflection element 30 at the impingement points of the coolant jets prevent the formation of a stagnation zone. Moreover, since there is no stagnation of the coolant, a build-up of a thermal boundary layer is avoided. Therefore, the deflection element 30 ensures that a constant stream of coolant impinges on the parts of the heat transfer plate 16 the power electronic components 12 are affixed to by ensuring that the coolant is transported to the outlet right after impinging on the heat transfer plate 16.

To ensure a quick and effective transport of the coolant to the outlet within the outlet duct 22, the cross section of the outlet duct 22 may be smaller compared to the cross-section of the inlet duct 18. The reduced cross-section of the outlet duct 22 leads to an increase in the velocity of the coolant, which means that the coolant which has taken up waste heat generated by the power electronic components 12 is transported to the outlet faster. In other words, the inlet duct 18 may serve as a plenum chamber having a lower velocity than the outlet duct 22.

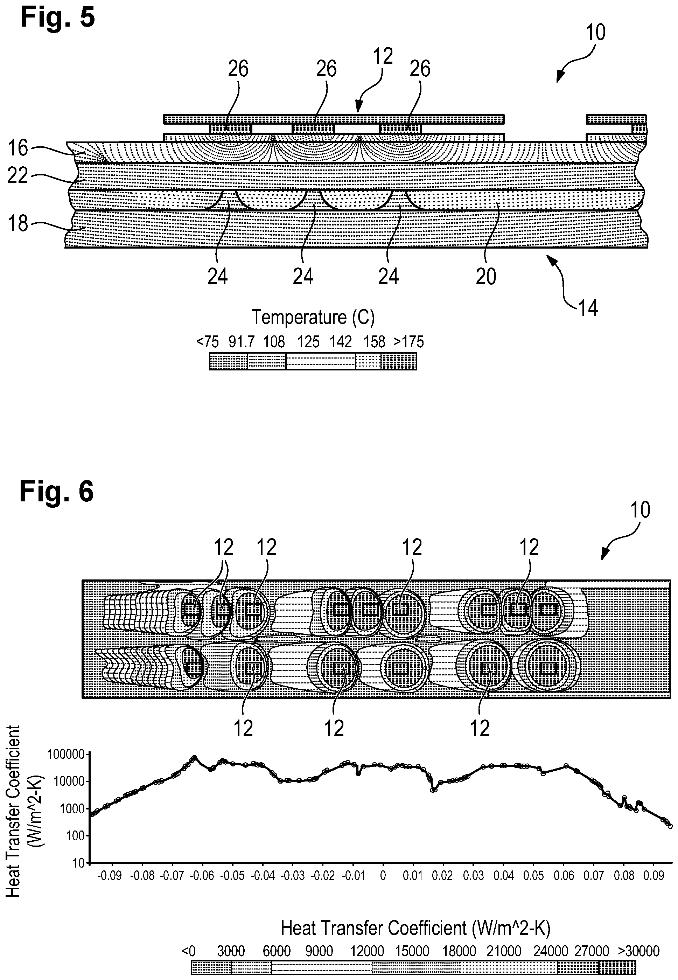

As can be seen in Figure 5, the temperature is highest for the power electronic components 12 and it decreases towards the inlet duct 18 of the coolant. Since the heat transfer coefficient is highest right at the parts where the power electronic components 12 affixed to the heat transfer plate 16, as shown in Figure 6, the power electronic components 12 are cooled effectively.

In order to avoid the build-up of heat and prevent coolant from bypassing, the cooling unit 14 may comprise a first deflection area 36 associated with the inlet duct 18. Additionally or alternatively, the cooling unit 14 may also comprise a second deflection area 38 associated with the outlet duct 22.

As shown in Figure 2, the first deflection area 36 is located opposite the inlet in the inlet duct 18 underneath the outlet of the outlet duct 22 whereas the second deflection area 38 is located above the inlet of the inlet duct 18 opposite the outlet in the outlet duct 22.

The deflection areas 36, 38 effectively delimit the inlet duct 18 and the outlet duct 22 respectively, such that they help guide, in particular deflect, the coolant towards the nozzle openings 24 and the outlet respectively.

Furthermore, as shown in Figure 4, the cooling unit 14 may further comprise a first deflection volume 40 and a second deflection volume 42. In particular, the first deflection volume 40 is located in the inlet duct 18 downstream of the nozzle opening 24 whereas the second deflection volume 42 is located upstream of the nozzle opening 24 in the outlet duct 22.

Accordingly, the first and second deflection volumes 40, 42 are located adjacent to the nozzle opening 24 and are offset from each other in regards to the nozzle opening 24.

Similar to the first and second deflection areas 36, 38, the deflection volumes 40, 42 are intended to help direct the coolant and avoid a build-up of heat. Put differently, the deflection volumes 40, 42 are intended to minimize transport losses.

In particular, the first deflection volume 40 prevents the coolant from bypassing the nozzle openings 24 and hence, helps with the creation of coolant jets. The second deflection volume 42 on the other hand helps with the deceleration of the coolant jet after impinging on the heat transfer plate 16 and directing the coolant towards the outlet.

Therefore, the inverter 10 is characterized by an excellent temperature control provided by the cooling unit 14. Moreover, the cooling unit 14 is cost effective and easier to produce than the solutions known from the state of the art.

## Claims

1. A cooling unit (14) for an inverter (10), in particular for an inverter (10) used in an electrically powered vehicle, the cooling unit (14) having an inlet duct (18), a nozzle plate (20), and an outlet duct (22), the outlet duct (22) being at least partially delimited by a heat transfer plate adapted to receive, at its side opposite to the outlet duct (22), a power electronic component (12), the nozzle plate (20) having a plurality of nozzle openings (24) which taper form the inlet duct (18) side towards the outlet duct (22) side, and the heat transfer plate being provided with a deflection element (30) at a position opposite the nozzle openings (24).

2. The cooling unit (14) according to claim 1, wherein the nozzle plate (20) comprises at least one nozzle opening (24) for each power electronic component (12), preferably for each connector (26) of the power electronic component (12).

3. The cooling unit (14) according to claim 1 or 2, wherein the heat transfer plate and the nozzle plate (20) extend in a plane parallel to the power electronic components (12), in particular wherein the heat transfer plate and the nozzle plate (20) extend horizontally.

4. The cooling unit (14) according to any one of the preceding claims, wherein the outlet duct (22) is formed between the heat transfer plate and the nozzle plate (20), and wherein the inlet duct (18) is formed between the nozzle plate (20) and a base (28) of the cooling unit (14).

5. The cooling unit (14) according to any one of the preceding claims, wherein the cross-section of the outlet duct (22) is smaller than the cross-section of the inlet duct (18).

6. The cooling unit (14) according to any one of the preceding claims, wherein the deflection element (30) is cone or dome shaped, in particular wherein the deflection element (30) is symmetrical with regard to a central axis extending through the corresponding nozzle opening (24).

7. The cooling unit (14) according to any one of the preceding claims, wherein the nozzle opening (24) in the nozzle plate (20) is circular.

8. The cooling unit (14) according to any one of the preceding claims, wherein the nozzle plate (20) comprises at least one projection extending from the nozzle plate (20) towards the heat transfer plate, wherein a tapered duct is formed inside the projecting corresponding to a nozzle opening (24) of the plurality of nozzle openings (24).

9. The cooling unit (14) according to any one of the preceding claims, wherein the nozzle plate (20) is formed by punching or die-casting.

10. The cooling unit (14) according to any one of the preceding claims, wherein the cooling unit (14) comprises a first deflection area (36) associated with the inlet duct (18) and/or a second deflection area (38) associated with the outlet duct (22).

11. An inverter (10) of an electrically powered vehicle, comprising at least one power electronic components (12) and a cooling unit (14) according to any one of the preceding claims, wherein the cooling unit (14) is removably mounted in the inverter (10).
